# EUROPEAN PATENT APPLICATION

(11) **EP 4 570 945 A1**
(43) Date of publication of application: **18.06.2025**
(21) Application number: 23866964.2
(22) Date of filing: 31.05.2023
(51) Int. Cl.: C23C 16/34, C23C 16/36, C23C 16/40, C23C 16/52, C22C 1/05

(54) **COATING CUTTING TOOL**

(30) Priority: 20.09.2022 CN 202211144578
(71) Applicant: Zhuzhou Cemented Carbide Cutting Tools Co., Ltd., Zhuzhou, Hunan 412007 (CN)
(72) Inventor: QU, Jun, Zhuzhou, Hunan 412007 (CN); CHEN, Xiangming, Zhuzhou, Hunan 412007 (CN); WANG, Shequan, Zhuzhou, Hunan 412007 (CN); WEN, Guanghua, Zhuzhou, Hunan 412007 (CN)
(74) Representative: Behr, Wolfgang
(86) International application number: PCT/CN2023/097591
(87) International publication number: WO 2024/060667

(57) **Abstract**

Disclosed in the present invention is a coated cutting tool, comprising a tool matrix (1) and an abrasion-resistant coating (2) arranged on the tool matrix, wherein the abrasion-resistant coating (2) at least comprises a AlₓTi₁₋ₓN_{1-y-z}C_{y}O_{z} coating (4), wherein 0.45≤x≤0.98, 0<y≤0.2, and 0<z≤0.18; on any section, perpendicular to a surface of the tool matrix, in the AlₓTi₁ₓNi_{1-y-x}C_{y}O_{z} coating (4) and in a growth direction of the AlₓTi₁ₓNi_{1-y-x}C_{y}O_{z} coating, atom fractions of elements Al, Ti and O in the AlₓTi₁₋ₓN_{1-y-z}C_{y}O_{z} coating change periodically. The coated cutting tool provided by the invention has good abrasion resistance for high-efficiency machining of difficult-to-machine materials such as cast iron, stainless steel and high-temperature alloy.

## Description

### Cross-reference to Related Application

The application is based on and claims priority to Chinese Patent Application No. 202211144578.5, filed on September 20, 2022, entitled "Coated Cutting Tool", which is incorporated herein by reference in its entirety, as one part of the application.

### Field of the Invention

The invention belongs to the technical field of coated cutting tools and related to a coated cutting tool, in particular to a coated cutting tool comprising an AlₓTi_{1 -x}N_{1-y-z}C_{y}O_{z} coating.

### Background of the Invention

Nowadays, high-speed and dry cutting has become predominant, and the rapid development of the coating technology plays a key role in the improvement of the tool performance and the progress of the cutting technology. Coated cutting tools have become an important symbol of modern cutting tools.

A TiAlN coating with the good properties of high hardness and oxidation temperature, good thermohardening and adhesion and low frictional coefficient and thermal conductivity has been widely applied to the field of high-performance cutting of difficult-to-machine materials. Because of the good chemical affinity of Al atoms and O atoms, an extremely thin amorphous Al₂O₃ layer will be formed in a tool-chip contact area under the action of a high temperature, thus forming a hard inert protective film. Therefore, a TiAlN-coated tool can still maintain its good abrasion resistance under a high temperature. Study shows that the structure and performance of a Ti₁₋ₓAlₓN coating depend on the Al content to a great extent, and with the increase in the Al content, the grain fineness, hardness and oxidation resistance of the coating will be improved to some extent. However, when the Al content exceeds a critical value, close-packed hexagonal AlN (h-AlN) will appear, leading to a sharp reduction in the mechanical properties. A PVD-Ti₁₋ₓAlₓN coating, the critical Al content of which is approximately 0.5-0.67at.%, is widely applied to the field of high-performance cutting of difficult-to-machine materials. A monophase cubic Ti₁₋ₓAlₓN coating with an Al content up to 0.9 can be prepared by a CVD method. Literature (Jie Zhang, et al. Impact of oxygen content on the thermal stability of Ti-Al-O-N coatings based on computational and experimental studies[J]. Acta Materialia 227 (2022) 117706) reported the preparation of a PVD TiAlNO coating by adding the element O to PVD TiAlN by means of a cathodic arc ion planting technique, and the performance the PVD TiAlNO coating is superior to that of a conventional PVD TiAlN coating. However, due to the limitation of the Al content in PVD TiAlN, the influence of the PVD TiAlNO coating on performance is still limited.

Patent Application Publication No.WO2007003648A1 discloses a monophase Ti₁₋ₓAlₓN (stoichiometric coefficient: 0.75<x≤0.93) coating with a cubic NaCl structure formed by CVD and a preparation method thereof. The Al content of the monophase cubic Ti₁₋ₓAlₓN coating prepared by the CVD method is up to 0.9. Literature (I. Endler, et al. Novel aluminum-rich Ti1-xAlxN coatings by LPCVD [J]. Surface & Coatings Technology 203 (2008) 530-533) reported a Ti₁₋ₓAlₓN coating, which shows good properties and is particularly suitable for high-speed and high-efficiency machining of materials such as cast iron and stainless steel.

A CVD-AlTiCN coating, as a typical component-modified coating, has the properties of high hardness and oxidization temperature, good thermohardening and adhesion, low frictional coefficient and thermal conductivity. Compared with a conventional MT-TiCN coating, by adding Al to an AlTiCN coating, the structural properties of the coating will be changed drastically, and with the increase in the Al content, the hardness and thermal resistance will be improved to some extent. Moreover, compared with an AlTiN coating, the hardness is improved due to lattice distortions caused by the addition of C. The development of the modern manufacturing industry leads to an increasingly greater demand for high-speed and high-efficiency machining of cast iron and steel and for difficult-to-machine materials such as high-viscosity materials and high-temperature alloy. The aforesaid coated tools still have the defects of poor coating peeling resistance and abrasion resistance in their application fields.

### Summary of the Invention

The technical issue to be settled by the invention is to overcome the defects in the prior art by providing a coated cutting tool, which has a nano-layered crystal structure and good abrasion resistance.

To settle the above technical issue, the invention adopts the following technical solution.

A coated cutting tool, comprising a tool matrix and an abrasion-resistant coating arranged on the tool matrix, wherein the abrasion-resistant coating at least comprises a AlₓTi₁₋ₓN_{1-y-z}C_{y}O_{z} coating, wherein 0.45≤x≤0.98, 0<y≤0.2, and 0< z≤0.18; on any section, perpendicular to a surface of the tool matrix, in the AlₓTi₁₋ₓN_{1-y-z}C_{y}O_{z} coating and in a growth direction of the AlₓTi₁₋ₓN_{1-y-z}C_{y}O_{z} coating, atom fractions of elements Al, Ti and O in the AlₓTi₁₋ₓN_{1-y-z}C_{y}O_{z} coating change periodically.

The coated cutting tool, preferably, wherein the AlₓTi₁₋ₓN_{1-y-z}C_{y}O_{z} coating is a multi-period coating formed by Al-rich layers and Ti-rich layers which are arranged alternately, and the Al-rich layers and the Ti-rich layers are nano-layered structures.

The coated cutting tool, preferably, wherein on any section, perpendicular to the surface of the tool matrix, in the AlₓTi₁₋ₓN_{1-y-z}C_{y}O_{z} coating and in the growth direction of the AlₓTi₁₋ₓN_{1-y-z}C_{y}O_{z} coating, an area, which is higher than a mean atom fraction of the element Al in the AlₓTi₁₋ₓN_{1-y-z}C_{y}O_{z} coating, of a distribution curve of the atom fraction of the element Al corresponds to a periodic width d_{Al} of the Al-rich layers, an area, which is lower than the mean atom fraction of the element Al in the AlₓTi₁₋ₓN_{1-y-z}C_{y}O_{z} coating, of the distribution curve of the atom fraction of the element Al corresponds to a periodic width d_{Ti} of the Ti-rich layers, 0.1 nm≤d_{Al}≤150 nm, and 0.1 nm≤d_{Ti}≤120 nm.

The coated cutting tool, preferably, wherein on any section, perpendicular to the surface of the tool matrix, in the AlₓTi₁₋ₓN_{1-y-z}C_{y}O_{z} coating and in the growth direction of the AlₓTi₁₋ₓN_{1-y-z}C_{y}O_{z} coating, a width between two adjacent maximum peaks of a distribution curve of the atom fraction of the element O in the AlₓTi₁₋ₓN_{1-y-z}C_{y}O_{z} coating is set as a periodic width d_{O}, and 0.1 nm≤d_{O}≤150 nm.

The coated cutting tool, preferably, wherein 0.5≤d_{O}/(d_{Al}+d_{Ti})≤1.5.

The coated cutting tool, preferably, wherein O-rich regions in the AlₓTi₁₋ₓN_{1-y-z}C_{y}O_{z} coating are located in the Al-rich layers, a distance from each said O-rich region to the nearest Ti-rich layer is d₁, and d₁≤0.5d_{O}.

The coated cutting tool, preferably, wherein the AlₓTi₁₋ₓN_{1-y-z}C_{y}O_{z} coating has face-centered cubic crystals accounting for at least 85% of its volume.

The coated cutting tool, preferably, wherein a microstructure of the AlₓTi₁₋ₓN_{1-y-z}C_{y}O_{z} coating is a fiber-like columnar structure; on the section perpendicular to the surface of the AlₓTi₁₋ₓN_{1-y-z}C_{y}O_{z} coating, a mean width d of columnar grains at a 90% thickness in the growth direction of the AlₓTi₁₋ₓN_{1-y-z}C_{y}O_{z} coating is d, a thickness of the AlₓTi₁₋ₓN_{1-y-z}C_{y}O_{z} coating is h, and the ratio of h to d satisfies h/d≥8.

The coated cutting tool, preferably, wherein a nano-hardness of the AlₓTi₁₋ₓN_{1-y-z}C_{y}O_{z} coating is greater than or equal to 28 GPa.

The coated cutting tool, preferably, wherein a total thickness of the abrasion-resistant coating is 2 µm-25 µm.

The coated cutting tool, preferably, wherein the abrasion-resistant coating further comprises a hard base layer arranged between the AlₓTi₁₋ₓN_{1-y-z}C_{y}O_{z} coating and the tool matrix, a thickness of the hard base layer is 0.1 µm-8 µm, and the hard base layer comprises at least one of a TiN layer, a TiCN layer, a TiC layer and an h-AlN layer which are deposited by CVD.

The coated cutting tool, preferably, wherein the thickness of the hard base layer is 0.1 µm-5 µm.

The coated cutting tool, preferably, wherein the thickness of the hard base layer is 0.1 µm-3 µm.

The coated cutting tool, preferably, wherein the abrasion-resistant coating further comprises a hard surface layer arranged on the AlₓTi₁₋ₓN_{1-y-z}C_{y}O_{z} coating, a thickness of the hard surface layer is greater than 0.1µm, and the hard surface layer comprises one or a combination of a TiN layer, a TiC layer, a TiCN layer and an h-AlN layer which are deposited by CVD.

The coated cutting tool, preferably, wherein on any section, perpendicular to the surface of the tool matrix, in the AlₓTi₁₋ₓN_{1-y-z}C_{y}O_{z} coating, concentrations of elements C and N change periodically.

In the invention, a matrix of the cutting tool is made from hard alloy, metal ceramic, ceramic, steel, cubic boron nitride or other ultrahard materials.

In the invention, an AlₓTi₁₋ₓN_{1-y-z}C_{y}O_{z} coating has a nano-hardness greater than 28GPa. A coating with an ultralow hardness has poor abrasion resistance. By means of a method provided by the invention, the AlₓTi₁₋ₓN_{1-y-z}C_{y}O_{z} coating has a high hardness.

In addition, a hard surface layer in the invention may be used together with the AlₓTi₁₋ₓN_{1-y-z}C_{y}O_{z} coating and a hard base layer to obtain better properties. Moreover, the hard surface layer in the invention may be used as a colored surface layer to obtain a better appearance and identifiability in use.

The coated cutting tool provided by the invention has good abrasion resistance, breakage resistance, peeling resistance, high-temperature deformation resistance, and other properties and shows extremely good properties in the field of machining of difficult-to-machine materials such as cast iron, stainless steel, alloy steel, cast steel and high-temperature alloy.

Compared with the prior art, the invention has the following advantages:
1. In view of the problems of limited Al content and poor cutting performance of an AlTiN coating, an O-contained AlTiCNO coating with a high Al content and a cubic crystal structure, the concentration of elements O, Ti and Al in which change periodically, is deposited on the surface of the cutting tool in the invention, such that the distribution of the elements O, Ti and Al in the AlTiCNO coating is optimized, thus significantly improving the oxidation resistance and abrasion resistance of the coating in high-speed and high-efficiency machining.
2. The AlTiCNO coating in the invention is a multi-period coating with a nano-structure formed by Al-rich layers with a high Al content and Ti-rich layers with a high Ti content, such that the structure of the Al-rich layers and the Ti-rich layers is optimized.

The coated cutting tool provided by the invention has good abrasion resistance and adhesion resistance and has extremely good properties in high-efficiency machining of difficult-to-machine materials such as cast iron, stainless steel and high-temperature alloy.

### Brief Description of the Drawings

FIG 1 is a structural diagram of a tool B according to Embodiment 1 of the invention.
FIG 2 is a TEM morphology picture of an AlₓTi₁₋ₓN_{1-y-z}C_{y}O_{z} coating in the tool B according to Embodiment 1 of the invention (STEM-HAADF -BF).
FIG. 3 is an energy spectrum analysis picture of a nano-layered area in the AlₓTi₁₋ₓN_{1-y-z}C_{y}O_{z} coating in the tool B according to Embodiment 1 of the invention, wherein A is a STEM-HAADF picture, B is a distribution graph of Al, C is a distribution graph of Ti, and D is a distribution graph of O.
FIG 4 is an AES analysis graph of the nano-layered area in the AlₓTi₁₋ₓN_{1-y-z}C_{y}O_{z} coating in the tool B according to Embodiment 1 of the invention.
FIG 5 is an AES analysis graph of elements C, N and O in the nano-layered area in the AlₓTi₁₋ₓN_{1-y-z}C_{y}O_{z} coating in the tool B according to Embodiment 1 of the invention.

### Reference signs:

1, tool matrix; 2, abrasion-resistant coating; 3, hard base layer; 4, AlₓTi₁₋ₓN_{1-y-z}C_{y}O_{z} coating; 5, hard surface layer; 6, Ti-rich layer; 7, Al-rich layer; 8, O-rich region.

### Detailed Description of the Invention

The invention is further described below in conjunction with accompanying drawings and specific preferred embodiments, but the following description should not be construed as limitations of the protection scope of the invention. Materials and instruments used in the following embodiments are all commercially available.

### Embodiment 1

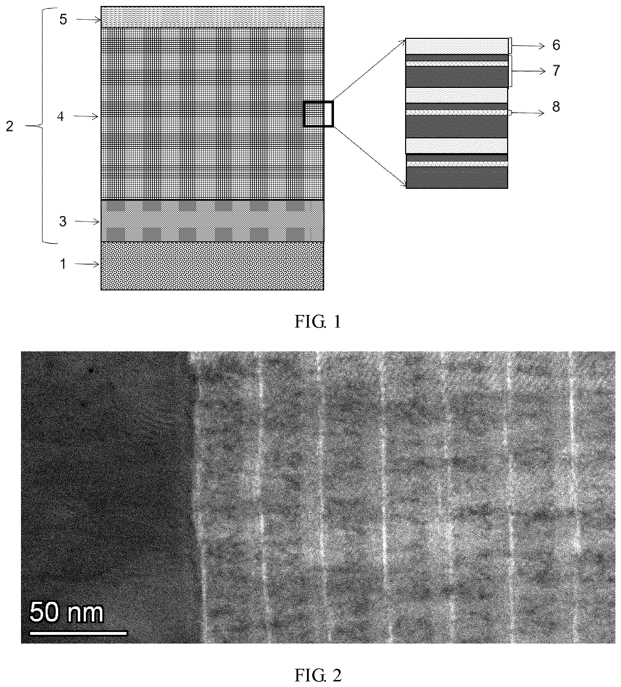

The invention provides a coated cutting tool, which as shown in FIG. 1, comprises a tool matrix 1 and an abrasion-resistant coating 2 arranged on the tool matrix 1, wherein the abrasion-resistant coating 2 at least comprises an AlₓTi₁₋ₓN_{1-y-z}C_{y}O_{z} coating 4, wherein 0.45≤x≤0.98, 0 < y≤0.2, and 0 < z≤0.18; on any section, perpendicular to a surface of the tool matrix 1, in the AlₓTi₁₋ₓN_{1-y-z}C_{y}O_{z} coating 4 and in a growth direction of the AlₓTi₁₋ₓN_{1-y-z}C_{y}O_{z} coating 4, atom fractions of elements Al, Ti and O in the AlₓTi₁₋ₓN_{1-y-z}C_{y}O_{z} coating 4 change periodically.

In this embodiment, the AlₓTi₁₋ₓN_{1-y-z}C_{y}O_{z} coating 4 is a multi-period coating formed by Al-rich layers 7 and Ti-rich layers 6 which are arranged alternately, and the Al-rich layers 7 and the Ti-rich layers 6 are nano-layered structures.

In this embodiment, on any section, perpendicular to the surface of the tool matrix 1, in the AlₓTi₁₋ₓN_{1-y-z}C_{y}O_{z} coating 4 and in the growth direction of the AlₓTi₁₋ₓN_{1-y-z}C_{y}O_{z} coating 4, an area, which is higher than a mean atom fraction of the element Al in the AlₓTi₁₋ₓN_{1-y-z}C_{y}O_{z} coating 4, of a distribution curve of the atom fraction of the element Al corresponds to a periodic width d_{Al} of the Al-rich layers 7, an area, which is lower than the mean atom fraction of the element Al in the AlₓTi₁₋ₓN_{1-y-z}C_{y}O_{z} coating 4, of the distribution curve of the atom fraction of the element Al corresponds to a periodic width d_{Ti} of the Ti-rich layers 6, 0.1 nm≤d_{Al}≤150 nm, and 0.1 nm≤d_{Ti}≤120 nm.

In this embodiment, on any section, perpendicular to the surface of the tool matrix 1, in the AlₓTi₁₋ₓN_{1-y-z}C_{y}O_{z} coating 4 and in the growth direction of the AlₓTi₁₋ₓN_{1-y-z}C_{y}O_{z} coating 4, a width between two adjacent maximum peaks of a distribution curve of the atom fraction of the element O in the AlₓTi₁₋ₓN_{1-y-z}C_{y}O_{z} coating 4 is set as a periodic width d_{O}, and 0.1 nm≤d_{O}≤150 nm.

In this embodiment, 0.5≤d_{O}/(d_{Al}+d_{Ti})≤1.5.

In this embodiment, O-rich regions 8 in the AlₓTi₁₋ₓN_{1-y-z}C_{y}O_{z} coating 4 are located in the Al-rich layers 7, a distance from each O-rich region 8 to the nearest Ti-rich layer 6 is d₁, and d₁≤0.5d_{O}.

In this embodiment, the AlₓTi₁₋ₓN_{1-y-z}C_{y}O_{z} coating 4 has face-centered cubic crystals accounting for at least 85% of its volume. Specifically, in this embodiment, the AlₓTi₁₋ₓN_{1-y-z}C_{y}O_{z} coating 4 has face-centered cubic crystals accounting for 92% of its volume.

In this embodiment, a microstructure of the AlₓTi₁₋ₓN_{1-y-z}C_{y}O_{z} coating 4 is a fiber-like columnar structure; on the section perpendicular to the surface of the AlₓTi₁₋ₓN_{1-y-z}C_{y}O_{z} coating 4, a mean width d of columnar grains at a 90% thickness in the growth direction of the AlₓTi₁₋ₓN_{1-y-z}C_{y}O_{z} coating 4 is d , a thickness of the AlₓTi₁₋ₓN_{1-y-z}C_{y}O_{z} coating 4 is h, and the ratio of h to d satisfies h/d≥8.

In this embodiment, a nano-hardness of the AlₓTi₁₋ₓN_{1-y-z}C_{y}O_{z} coating 4 is greater than or equal to 28 GPa.

In this embodiment, a total thickness of the abrasion-resistant coating is 2 µm-25 µm.

In this embodiment, the abrasion-resistant coating 2 further comprises a hard base layer 3 arranged between the AlₓTi₁₋ₓN_{1-y-z}C_{y}O_{z} coating 4 and the tool matrix 1, a thickness of the hard base layer 3 is 0.1 µm-8 µm, and the hard base layer 3 comprises at least one of a TiN layer, a TiCN layer, a TiC layer and an h-AlN layer which are deposited by CVD. Specifically, in this embodiment, the TiN layer is used as the hard base layer 3, and a deposition thickness is 1.0 µm.

In this embodiment, the abrasion-resistant coating 2 further comprises a hard surface layer 5 arranged on the AlₓTi₁₋ₓN_{1-y-z}C_{y}O_{z} coating 4, a thickness of the hard surface layer 5 is greater than 0.1 µm, and the hard surface layer 5 comprises one or a combination of a TiN layer, a TiC layer, a TiCN layer and an h-AlN layer which are deposited by CVD. In this embodiment, a tool B uses an AlN coating as the hard surface layer, and the thickness of the hard surface layer is 0.2 µm.

In this embodiment, on any section, perpendicular to the surface of the tool matrix 1, in the AlₓTi₁₋ₓN_{1-y-z}C_{y}O_{z} coating 4, concentrations of elements C and N change periodically.

In this embodiment, the tool matrix 1 is, but not limited to, a hard alloy matrix, and the tool matrix 1 may also be a matrix made from metal ceramic, ceramic, steel, cubic boron nitride, or other ultrahard materials.

A method for preparing the coated cutting tool in this embodiment comprises the following steps:
(1) Mixed powder comprising Co with a mass fraction of 9%, TaNbC with a mass fraction of 2.5%, Cr₃C₂ with a mass fraction of 0.35%, and the balance WC with a granularity of 1.5-1.8 µm is pressed, sintered and ground to manufacture a WC-Co hard alloy matrix in a blade shape specified by SEET12T3-DM of the ISO standard.
(2) To prepare an indexable coated cutting blade, coating is performed in a CVD coating furnace with a low-pressure system (LPS), such as a Bernex BPX530L CVD coating device. A hard base layer TiN is deposited on the tool matrix 1 by means of an existing conventional CVD process, wherein the deposition thickness is 1.0 µm.
(3) An AlₓTi₁₋ₓN_{1-y-z}C_{y}O_{z} coating 4 is deposited: the AlₓTi₁₋ₓN_{1-y-z}C_{y}O_{z} coating 4 is deposited on the hard base layer TiN by a low-pressure CVD process; reactant gas is guided into the coating furnace by means of two gas lines; after the two paths of gas T1 and T2 are preheated and mixed, the AlₓTi₁₋ₓN_{1-y-z}C_{y}O_{z} coating 4 is deposited in a CVD reactor by means of a hollow graphite rod, which is provided with holes all around and connected to a preheater, wherein deposition parameters are shown in Table 1. Wherein, for a tool A, the rotational speed of the preheater and the graphite rod is 1 rpm; for a tool B, the rotational speed of the preheater and the graphite rod is 2 rpm.
(4) A hard surface layer 5 is deposited: for the tool B, the hard surface layer 5 (an AlN coating) is further deposited on the surface of the AlₓTi₁₋ₓN_{1-y-z}C_{y}O_{z} coating 4 in the CVD coating furnace provided with the LPS, and reactant gas is guided into the coating furnace by means of two gas lines, wherein in one path of gas T1, the volume fraction of AlCl₃ is 1.34%, and the volume fraction of H₂ is 98.66%; in the other path of gas T2, the volume fraction of NH₃ is 16.67%, and the volume fraction of H₂ is 83.33%; the volume ratio T1/T2 is 1:1. The deposition temperature is 760°C, the deposition pressure is 5 mbar, and the deposition time is 20 min.

**Table 1 Deposition process parameters of the AlₓTi₁₋ₓN_{1-y-z}C_{y}O_{z} coating in Embodiment 1**

| Tool No. | T1 (volume %) | | | | | T2 (volume %) | | T1 / T2 | Tem pera ture [°C] | Press ure [mbar ] | Time [min] |
|---|---|---|---|---|---|---|---|---|---|---|---|
| | TiCl₄ | AlCl₃ | CO | CO₂ | H₂ | NH₃ | H₂ | | | | |
| A (the invention) | 0.31 | 0.89 | 0 | 0.22 | 98.58 | 8.93 | 91.07 | 1:1 | 760 | 3 | 135 |
| B (the invention) | 0.25 | 0.92 | 0.12 | 0.27 | 98.44 | 5.31 | 94.69 | 1:2 | 730 | 5 | 150 |

### Detection of the thickness and components of the coating:

The components of the coating are analyzed by SEM-EDS. As shown in FIG. 2, the cross-section of the cutting tool with the AlₓTi₁₋ₓN_{1-y-z}C_{y}O_{z} coating is studied by scanning electron microscopy (SEM). A diamond saw blade is cut in a direction perpendicular to upper and lower surfaces of the blade to obtain a vertical cross-section comprising coatings, and after mounting, grinding and polishing, the thicknesses of different layers of the coating are determined by SEM, as shown in Table 2.

**Table 2 Thicknesses of the coatings in Embodiment 1**

| Tool No. | Coating thickness (µm) | | |
|---|---|---|---|
| | Hard base layer TiN | AlₓTi₁₋ₓN_{1-y-z}C_{y}O_{z} coating | Hard surface layer |
| A | 1.0 | 7.5 | / |
| B | 1.0 | 9.2 | 0.2 |

The thickness of the AlₓTi₁₋ₓN_{1-y-z}C_{y}O_{z} coating 4 in the invention is in a positive correlation with the deposition time and can be adjusted by controlling the deposition time.

The components of the coating are analyzed by SEM-EDS, and analysis results are shown in Table 3. In the AlₓTi₁₋ₓN_{1-y-z}C_{y}O_{z} coating in the invention, the content of Al is high, the stoichiometric coefficient x of Al is 0.45-0.98, the stoichiometric coefficient y of C is 0<y≤0.2, and the stoichiometric coefficient z of O is 0.01-0.18.

**Table 3 Components of the AlₓTi₁₋ₓN_{1-y-z}C_{y}O_{z} coating in Embodiment 1**

| Tool No. | Ti | Al | C | N | O | X | y | Z |
|---|---|---|---|---|---|---|---|---|
| A | 10.92 | 34.58 | 5.45 | 44.69 | 4.36 | 0.76 | 0.10 | 0.08 |
| B | 9.12 | 41.55 | 5.92 | 38.48 | 4.93 | 0.82 | 0.12 | 0.10 |

The mean grain width d of the coating is determined by SEM. The thickness h of the AlₓTi₁₋ₓN_{1-y-z}C_{y}O_{z} coating in the prepared coated cutting tools, the mean width of columnar grains at a 90% thickness in the growth direction of the AlₓTi₁₋ₓN_{1-y-z}C_{y}O_{z} coating 4 on a cross-section perpendicular to the surface of the coating, and the ratio of h to d are shown in Table 4.

**Table 4 Thickness and mean grain width d of the AlₓTi₁₋ₓN_{1-y-z}C_{y}O_{z} coating in Embodiment 1**

| Coating No. | Thickness h of AlₓTi₁₋ₓN_{1-x-z}N_{1-y-z}C_{y}O_{z} H (µm) | Mean grain width at 90% thickness d (µm) | h/d |
|---|---|---|---|
| A (the invention) | 7.5 | 0.85 | 8.8 |
| B (the invention) | 9.2 | 1.1 | 8.4 |

### Detection of the structure and elements of the coating:

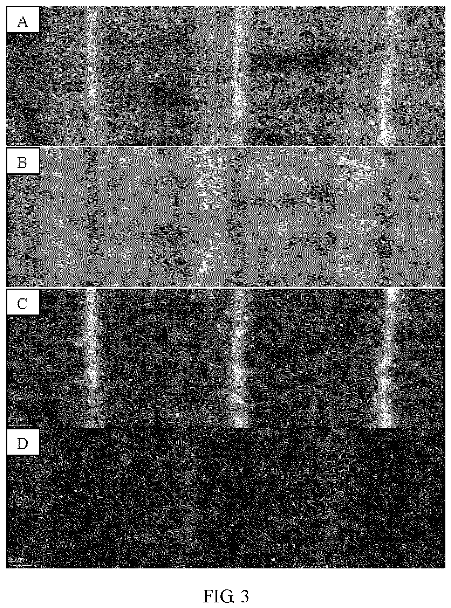

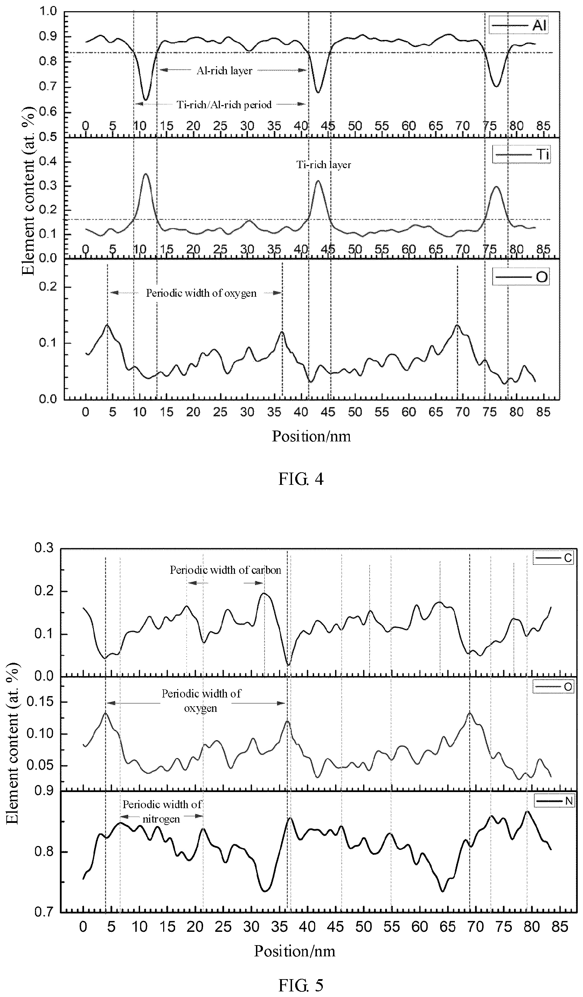

As shown in FIG 2 which illustrates the TEM morphology of the AlₓTi₁₋ₓN_{1-y-z}C_{y}O_{z} coating (STEM-HAADF -BF) in the tool B in the invention, bright and dark fringes of the Ti-rich layers 6 and the Al-rich layers 7 can be seen in a bright field image mode. An area comprising the Ti-rich layers 6 and the Al-rich layers 7 in FIG 2 is selected for energy spectrum surface analysis, and analysis results are shown in FIG. 3. According to the analysis results, the Ti-rich region and the Al-rich region change alternately and periodically, and the O-rich regions are located in the Al-rich layers 7. An AES element content (intensity) distribution graph is plotted according to energy spectrum analysis data of the area in FIG. 3, as shown in FIG 4. According to FIG 4, in the growth direction of the AlₓTi₁₋ₓN_{1-y-z}C_{y}O_{z} coating 4, the AlₓTi₁₋ₓN_{1-y-z}C_{y}O_{z} coating 4 is formed by Ti-rich layers 6 and Al-rich layers 7 which are arranged alternately, and the concentration of Ti and the concentration of Al change periodically; the Al content of the Ti-rich layers 6 is lower than the Al content of the Al-rich layers 7, the Ti content of the Ti-rich layers 6 is higher than the Ti content of the Al-rich layers 7, and a maximum peak of the Al content corresponds to a minimum peak of the Ti content. Moreover, the concentration of the element O also changes periodically. According to FIG. 4, the periodic width d_{Al} of the Al-rich layers 7 is about 28.5 nm, the periodic width d_{Ti} of the Ti-rich layers 6 is about 4 nm. The periodic width of two complete Ti-rich layers/Al-rich layers 7 in FIG 4 is about 65 nm, the periodic width d_{Al}+d_{Ti} of a single Ti-rich layer/Al-rich layer is about 32.5 nm. The width between three successive maximum peaks on a distribution curve of the element O is about 65 nm, so the periodic width do of the periodic concentration change of the element O is about 32.5 nm. The O-rich regions 8 are located in the Al-rich layers 7, and the distance d₁ from each O-rich region 8 to the nearest Ti-rich layer 6 is about 5 nm. Because the sum of the atom contents of the elements C, N and O is 100%, the periodic concentration change of the element O will inevitably lead to a corresponding periodic concentration change of one or two of the elements C and N. It can be obtained, by the same detection method, that the periodic width d_{Al} of the Al-rich layers 7 in the tool A is about 15 nm, the periodic width d_{Ti} of the Ti-rich layers 6 is about 3 nm, and the periodic width d_{Al+}d_{Ti} of a single Ti-rich layer/Al-rich layer is about 18 nm. The periodic width do of the periodic concentration change of the element O is about 18 nm. The O-rich regions 8 are located in the Al-rich layers 7, and the distance d₁ from each O-rich region 8 to the nearest Ti-rich layer 6 is about 6 nm. An AES element content (intensity) distribution graph is plotted according to energy spectrum analysis data of the area in FIG. 3, as shown in FIG. 5. According to FIG. 5, the concentration of the element C, the concentration of the element N and the concentration of the element O change periodically in the growth direction of the AlₓTi₁₋ₓN_{1-y-z}C_{y}O_{z} coating 4.

Compared with elements Al, Ti and O, the change periods of the concentrations of the elements C and N are more complex.

### Detection of the nano thickness of the coating

A nano-hardness test is performed on the coated tools after polishing, as shown in Table 5.

**Table 5 Nano-hardness test result of the AlₓTi₁₋ₓN_{1-y-z}C_{y}O_{z} coating in Embodiment 1**

| Performance | Tool A | Tool B |
|---|---|---|
| Hv/GPa | 32.6±1.1 | 30.3±0.8 |

### Performance comparison test:

A cutting performance comparison result is performed on the cutting tools A and B produced in Embodiment 1 of the invention and contrast coated cutting tools H1 and H2 with the same tool matrix and of the same type as Embodiment 1. Wherein, the contrast cutting tools are the tool H1 TiN/MT-TiCN/TiN (total thickness: 8 µm) and the tool H2 TiN/ MT-TiCN/Al₂O₃ (total thickness: 9 µm) coated by an existing CVD process.

A milling test shown in Table 6 is performed on the above cutting tools.

**Table 6 Conditions of the milling test**

| Workpiece | Cutting speed (m/min) | Feed (mm/z) | Cutting depth (mm) | Cutting width (mm) | Cutting method |
|---|---|---|---|---|---|
| 1Cr18Ni9Ti | 260 | 0.20 | 1 | 50 | Dry milling |

**Table 7 Comparison of test results**

| Products | Milling life (min) | Abrasion V_{b}(mm) |
|---|---|---|
| A (the invention) | 28 | 0.29 |
| B (the invention) | 24 | 0.30 |
| H1 (contrast tool) | 13 | 0.31 |
| H2 (contrast tool) | 12 | 0.38 |

According to Table 7, the life of the coated tools in the invention is significantly superior to that of the contrast tools and show good abrasion resistance.

### Embodiment 2 Cutting test

Mixed powder containing 10% of Co, 0.90% of Cf₃C₂, and WC with a granularity of 0.8-1.0 µm is pressed, sintered and ground to manufacture WC-Co hard alloy matrixes C and D in a blade shape specified by WNMG080408-HF of the ISO standard. Tools C1 and D1 are prepared separately as follows: for the tool C1, a hard base layer TiN and an AlₓTi₁₋ₓN_{1-y-z}C_{y}O_{z} coating 4 are deposited on the tool matrix by means of the same CVD process as the tool A in Embodiment 1, wherein the thickness of TiN and the thickness of AlₓTi₁₋ₓN_{1-y-z}C_{y}O_{z} are respectively 1.0 µm and 7.3 µm; then, an h-AlN coating is deposited on the surface of the AlₓTi₁₋ₓN_{1-y-z}C_{y}O_{z} coating 4 by means of the same CVD process as the tool B, wherein the thickness of the h-AlN coating is 0.2 µm; for the tool D1 used as a contrast tool, a single-layer TiAl coating is deposited by means of a conventional PVD process, wherein the thickness of the TiAlN coating in D1 is 3.2 µm.

A turning test shown in Table 8 is performed on the tools C1 and D1.

**Table 8 Conditions of the turning test**

| Workpiece | Cutting speed (m/min) | Feed (mm/z) | Cutting depth (mm) | Cutting method |
|---|---|---|---|---|
| GH4169 | 80 | 0.1 | 1 | Water cooling |

**Table 9 Comparison of test results**

| Product | Life (min) | Abrasion V_{b}(mm) |
|---|---|---|
| C1 (the invention) | 27 | 0.30 |
| D1 (contrast tool) | 18 | 0.39 |

According to Table 9, under the same machining time, the abrasion resistance of the coated tool provided by the invention is obviously superior to that of the contrast tool, and the coated cutting tool provided by the invention shows good abrasion resistance.

The above embodiments are merely preferred ones of the invention and should not be construed as limitations of the invention in any form. Although the invention has been disclosed above with reference to preferred embodiments, these embodiments are not used to limit the invention. Any skilled in the art can make many possible transformations and embellishments to the technical solution of the invention or obtain equivalent embodiments by means of approaches and technical contents disclosed above without departing from the spirit and technical solution of the invention. Therefore, any simple modifications, equivalent substitutions, transformations and embellishments made to the above embodiments according to the technical essence of the invention without departing from the contents of the technical solution of the invention still fall within the protection scope of the technical solution of the invention.

## Claims

1. A coated cutting tool, comprising a tool matrix and an abrasion-resistant coating arranged on the tool matrix, wherein the abrasion-resistant coating at least comprises a AlₓTi₁₋ₓN_{1-y-z}C_{y}O_{z} coating, wherein 0.45≤x≤0.98, 0<y≤0.2, and 0<z≤0.18; on any section, perpendicular to a surface of the tool matrix, in the AlₓTi₁₋ₓN_{1-y-z}C_{y}O_{z} coating and in a growth direction of the AlₓTi₁₋ₓN_{1-y-z}C_{y}O_{z} coating, atom fractions of elements Al, Ti and O in the AlₓTi₁₋ₓN_{1-y-z}C_{y}O_{z} coating change periodically.

2. The coated cutting tool according to Claim 1, wherein the AlₓT₁₋ₓN_{1-y-z}C_{y}O_{z} coating is a multi-period coating formed by Al-rich layers and Ti-rich layers which are arranged alternately, and the Al-rich layers and the Ti-rich layers are nano-layered structures.

3. The coated cutting tool according to Claim 2, wherein on any section, perpendicular to the surface of the tool matrix, in the AlₓTi₁₋ₓN_{1-y-z}C_{y}O_{z} coating and in the growth direction of the AlₓTi₁₋ₓN_{1-y-z}C_{y}O_{z} coating, an area, which is higher than a mean atom fraction of the element Al in the AlₓTi₁₋ₓN_{1-y-z}C_{y}O_{z} coating, of a distribution curve of the atom fraction of the element Al corresponds to a periodic width d_{Al} of the Al-rich layers, an area, which is lower than the mean atom fraction of the element Al in the AlₓTi₁₋ₓN_{1-y-z}C_{y}O_{z} coating, of the distribution curve of the atom fraction of the element Al corresponds to a periodic width d_{Ti} of the Ti-rich layers, 0.1 nm≤d_{Al}≤150 nm, and 0.1 nm≤d_{Ti}≤120 nm.

4. The coated cutting tool according to Claim 3, wherein on any section, perpendicular to the surface of the tool matrix, in the AlₓTi₁₋ₓN_{1-y-z}C_{y}O_{z} coating and in the growth direction of the AlₓTi₁₋ₓN_{1-y-z}C_{y}O_{z} coating, a width between two adjacent maximum peaks of a distribution curve of the atom fraction of the element O in the AlₓTi₁₋ₓN_{1-y-z}C_{y}O_{z} coating is set as a periodic width d_{O}, and 0.1 nm≤d_{O}≤150 nm.

5. The coated cutting tool according to Claim 4, wherein 0.5≤d_{O}/(d_{Al}+d_{Ti})≤1.5.

6. The coated cutting tool according to Claim 4, wherein O-rich regions in the AlₓTi₁₋ₓN_{1-y-z}C_{y}O_{z} coating are located in the Al-rich layers, a distance from each said O-rich region to the nearest Ti-rich layer is d₁, and d₁≤0.5d_{O}.

7. The coated cutting tool according to any one of Claims 1-6, wherein the AlₓTi₁₋ₓN_{1-y-z}C_{y}O_{z} coating has face-centered cubic crystals accounting for at least 85% of its volume.

8. The coated cutting tool according to any one of Claims 1-6, wherein a microstructure of the AlₓTi₁₋ₓN_{1-y-z}C_{y}O_{z} coating is a fiber-like columnar structure; on the section perpendicular to the surface of the AlₓTi₁₋ₓN_{1-y-z}C_{y}O_{z} coating, a mean width d of columnar grains at a 90% thickness in the growth direction of the AlₓTi₁₋ₓN_{1-y-z}C_{y}O_{z} coating is d, a thickness of the AlₓTi₁₋ₓN_{1-y-z}C_{y}O_{z} coating is h, and the ratio of h to d satisfies h/d≥8.

9. The coated cutting tool according to any one of Claims 1-6, wherein a nano-hardness of the AlₓTi₁₋ₓN_{1-y-z}C_{y}O_{z} coating is greater than or equal to 28 GPa.

10. The coated cutting tool according to any one of Claims 1-6, wherein a total thickness of the abrasion-resistant coating is 2 µm-25 µm.

11. The coated cutting tool according to any one of Claims 1-6, wherein the abrasion-resistant coating further comprises a hard base layer arranged between the AlₓTi₁₋ₓN_{1-y-z}C_{y}O_{z} coating and the tool matrix, a thickness of the hard base layer is 0.1 µm-8 µm, and the hard base layer comprises at least one of a TiN layer, a TiCN layer, a TiC layer and an h-AlN layer which are deposited by CVD.

12. The coated cutting tool according to Claim 11, wherein the thickness of the hard base layer is 0.1 µm-5 µm.

13. The coated cutting tool according to Claim 12, wherein the thickness of the hard base layer is 0.1 µm-3 µm.

14. The coated cutting tool according to any one of Claims 1-6, wherein the abrasion-resistant coating further comprises a hard surface layer arranged on the AlₓTi₁₋ₓN_{1-y-z}C_{y}O_{z} coating, a thickness of the hard surface layer is greater than 0.1 µm, and the hard surface layer comprises one or a combination of a TiN layer, a TiC layer, a TiCN layer and an h-AlN layer which are deposited by CVD.

15. The coated cutting tool according to any one of Claims 1-6, wherein on any section, perpendicular to the surface of the tool matrix, in the AlₓTi₁₋ₓN_{1-y-z}C_{y}O_{z} coating, concentrations of elements C and N change periodically.
